# EUROPÄISCHE PATENTSCHRIFT

(11) **EP 0 992 110 B1**
(45) Veröffentlichungstag und Bekanntmachung des Hinweises auf die Patenterteilung: **04.10.2001**
(21) Anmeldenummer: 98941264.8
(22) Anmeldetag: 03.07.1998
(51) Int. Cl.: H03H 7/01, H03J 5/24

(54) **BANDPASSFILTER**
BAND-PASS FILTER
FILTRE PASSE-BANDE

(30) Priorität: 03.07.1997 DE 19728464
(43) Veröffentlichungstag der Anmeldung: 12.04.2000
(73) Patentinhaber: Infineon Technologies AG, 81669 München (DE)
(72) Erfinder: MUSIOL, Lothar, D-81735 München (DE); KUHN, Ralph, D-85591 Vaterstetten (DE)
(74) Vertreter: Zedlitz, Peter, Dipl.-Inf.
(86) Internationale Anmeldenummer: DE9801846
(87) Internationale Veröffentlichungsnummer: WO9901930

(56) Entgegenhaltungen:
- FR-A- 952 403
- US-A- 5 483 209
- "SWITCHABLE BANDSELECTOR" ELEKTOR ELECTRONICS., Bd. 13, Nr. 147, Juli 1987, Seite 64 XP002087971 CANTERBURY GB

## Beschreibung

Die Erfindung bezieht sich auf einen Bandpaßfilter, insbesondere zur Verwendung in Schaltungsanordnungen der HF-Technik.

In vielen Schaltungsanordnungen der HF-Technik, z. B. in Schaltungsanordnungen zur lückenlosen Aufteilung eines größeren Frequenzbereiches (z. B. den TV-Frequenzbereich) in mehrere kleinere Frequenzbänder, werden Bandpässe mit vergleichsweiser großer Durchlassbandbreite bei gleichzeitig vergleichsweise steilen Flanken zum Sperrbereich und geringer Dämpfung im Durchlassbereich benötigt.

Aus der französischen Druckschrift FR 952403 ist eine Bandpaßfilterschaltung bekannt. Hierbei ist ein Kondensator mit einem parallelen LC-Glied in Serie geschalten. Die Filter-Vierpol-Schaltung weist ausgangsseitig ein zusätzliches paralleles LC-Glied auf.

Aus der Druckschrift US 5,483,209 ist eine Schaltung zum Umschalten zwischen verschiedenen Empfangsbändern mit variabler Dämpfungssteuerung bekannt. Die Schaltung weist mehrere Bandpaßfilter auf, welche auf die verschiedenen Eingangsempfangsfrequenzen abgestimmt sind. Zusätzlich weist die Schaltung mehrere variable Dämpfungsdioden auf, deren Impedanz mittels einer AGC gesteuert werden. Mehrere Schaltdioden dienen zur Auswahl des auf das Eingangssignal abgestimmten Bandpaßfilters.

Der vorliegenden Erfindung liegt die Aufgabe zugrunde, ein Bandpassfilter zu entwickeln, das die oben genannten Anforderungen erfüllt.

Diese Aufgabe wird durch einen Bandpaßfilter mit den Merkmalen des Anspruches 1 gelöst. Vorteilhafte Weiterbildungen der Erfindung sind Gegenstand der Unteransprüche 2 bis 4.

Bei dem erfindungsgemäßen Bandpaßfilter ist vorgesehen, daß
a) zwischen einem Bandpassfilter-Eingang und einem Bandpassfilter-Ausgang eine Reihenschaltung, bestehend aus einer ersten Kapazität, einem ersten parallelen LC-Glied, einer zweiten Kapazität und einer Induktivität, angeordnet ist, wobei die einzelnen Elemente in der vorgenannten Reihenfolge direkt hintereinandergeschaltet sind;
b) in eine Verbindungsleitung zwischen dem ersten parallelen LC-Glied und der zweiten Kapazität ein zweites paralleles LC-Glied angeschlossen ist, dessen zweiter Anschluss über eine dritte Kapazität an ein festes Bezugspotential gekoppelt ist und
c) in einer Verbindungsleitung zwischen der zweiten Kapazität und der Induktivität ein drittes paralleles LC-Glied angeschlossen ist, dessen zweiter Anschluss direkt oder über eine vierte Kapazität an das feste Bezugspotential gekoppelt ist.

Optional ist die Verbindungsleitung zwischen der zweiten Kapazität und der Induktivität über eine fünfte Kapazität an das feste Bezugspotential, z. B. Masse, gekoppelt.

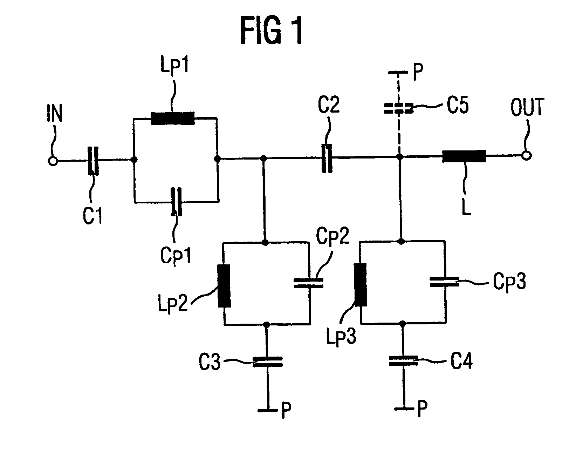

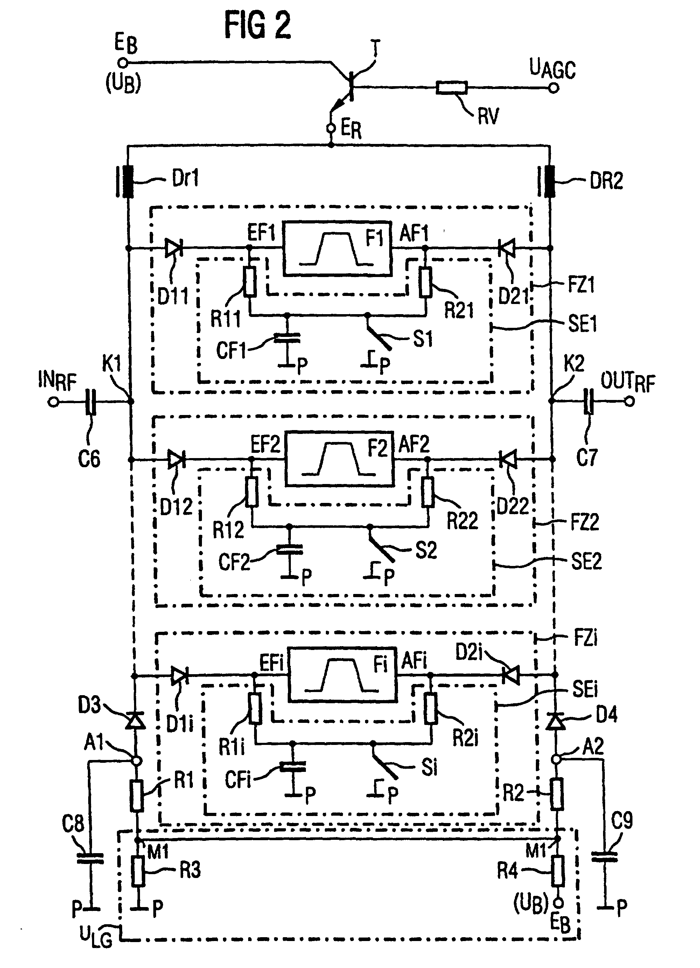

Das erfindungsgemäße Verfahren wird im folgenden anhand eines Ausführungsbeispieles in Verbindung mit den Figuren 1 und 2 näher erläutert. Es zeigen:
Figur 1 einen Schaltplan des Auführungsbeispieles und
Figur 2 eine Schaltungsanordnung mit Bandpässen gemäß dem Ausführungsbeispiel.

Das Bandpassfilter gemäß dem Ausführungsbeispiel von Figur 1 weist zwischen einem Bandpassfiltereingang IN und einem Bandpassfilterausgang OUT eine Reihenschaltung, bestehend aus einer ersten Kapazität C1, einem ersten parallelen LC-Glied L_{P}1/C_{P}1, einer zweiten Kapazität C2 und einer Induktivität L auf. Diese Schaltungselemente sind in der vorgenannten Reihenfolge hintereinandergeschaltet. Zwischen dem ersten parallelen LC-Glied L_{P}1/C_{P}1 und der zweiten Kapazität C2 ist ein erster Anschluss eines zweiten parallelen LC-Gliedes L_{P}2/C_{P}2 angeschlossen, dessen zweiter Anschluss über eine dritte Kapazität C3 an ein festes Bezugspotential P gekoppelt ist. Zwischen der zweiten Kapazität C2 und der Induktivität L ist ein erster Anschluss eines dritten parallelen LC-Gliedes L_{P}3/C_{P}3 angeschlossen, dessen zweiter Anschluss direkt oder über eine vierte Kapazität C4 an das feste Bezugspotential P gekoppelt ist.

Zwischen der zweiten Kapazität C2 und der Induktivität L kann wahlweise eine fünfte Kapazität C5 (gestrichelt eingezeichnet) zum festen Bezugspotentiel P hinzugefügt sein.

Optional kann weiterhin zwischen der zweiten Kapazität C2 und der Induktivität L ein Serienkreis zum festen Bezugspotential P angeschlossen sein.

An Stelle der Induktivitäten L,Lp1,Lp2,Lp3 können Streifenleitungen eingesetzt werden.

Bei der Schaltungsanordnung gemäß der Figur 2 ist zwischen einem Wechselspannungseingangsanschluss IN_{RF} und einem Wechselspannungsausgangsanschluss OUT_{RF} eine Parallelschaltung, bestehend aus einer Mehrzahl von Frequenzbereichsfilterzweigen FZ1,FZ2,...,FZi angeordnet, von denen jeder einen Bandpaßfilter Bandpassfilter F1, F2,...,Fi gemäß dem Ausführungsbeispiel von Figur 1 aufweist.

Zwischen dem Wechselspannungseingangsanschluss IN_{RF} und einem ersten Knotenpunkt K1 der Parallelschaltung ist eine sechste Kapazität C6 und zwischen einem zweiten Knotenpunkt K2 der Parallelschaltung und dem Wechselspannungsausgangsanschluss OUT_{RF} ist eine siebte Kapazität C7 angeschlossen. Diese beiden Kapazitäten C6 und C7 dienen im Wesentlichen zur Gleichspannungsentkopplung der Wechselspannungsanschlüsse IN_{RF} und OUT_{RF}.

An die Knotenpunkte K1 und K2 ist über die beiden Drosselelemente Dr1,Dr2 jeweils ein Regelspannungsanchluß E_{R} angekoppelt, über den im Betrieb den Knotenpunkten K1 und K2 ein Gleichstrom zugeführt wird. An Stelle der Drosselelemente Dr1 und Dr2 sind auch geeignete ohmsche Widerstände verwendbar.

Am Regelspannungsanschluß ER ist in diesem Beispiel der Emitter eines ein pnp-Transistors T angeschlossen, dessen Kollektor mit dem Betriebsspannungseingang E_{B} und dessen Basis über einen elektrischen Widerstand RV mit einem Steuerspannungsanschluß U_{AGC} verbunden ist.

Jeder Frequenzbereichsfilterzweig FZ1, FZ1, ..., FZi besteht aus einem Bandpassfilter F1,F2,...,Fi, der zwischen zwei Dioden D11,D21;D12,D22;...;D1i,D2i, bevorzugt PIN-Dioden, mit diesen in Reihe geschaltet ist. Die beiden PIN-Dioden sind bezüglich ihrer Durchlassrichtungen entgegengesetzt gerichtet geschaltet.

An jedem Bandpassfilter F1,F2,...,Fi ist zwischen den beiden zugehörigen Dioden D11,D21;D12,D22;...;D1i,D2i eine Gleichstromzuführung, bestehend aus einem ersten Widerstand R11,R12,...,R1i und einem zweiten Widerstand R21,R22,...,R2i angeschlossen. Der erste Widerstand R11,R12,...,R1i und der zweite Widerstand R21,R22,...,R2i sind jeweils einerseits an den Eingang EF1,EF2,...,EFi bzw. an den Ausgang AF1,AF2,...,AFi des zugehörigen Bandpassfilter F1,F2,...,Fi angeschlossen und andererseits miteinander verbunden. Die jeweilige Verbindungsleitung zwischen den beiden Widerständen R11,R21;R12,R22;...;R1i,R2i ist jeweils mittels einer Kapazität CF1,CF2,...,CFi wechselstrommäßig abgeblockt und jeweils mit einem ersten Schalteranschluß eines "Ein-Aus"-Schalters S1,S2,...,Si (bevorzugt ein elektronischer Schalter, z. B. ein Open-Kollektor-Schaltausgang eines integrierten Schaltkreises) verbunden, dessen zweiter Schalteranschluss auf einem festen Bezugspotential liegt.

Parallel zu den Frequenzbereichsfilterzweigen FZ1,FZ1,...,FZi ist eine Reihenschaltung aus einer dritten Diode D3, einem ersten Widerstand R1, einem zweiten Widerstand R2 und einer vierten Diode D4 angeschlossen, in der die beiden Dioden D3 und D4 bezüglich ihrer Durchlassrichtung entgegengesetzt gerichtet geschaltet und bevorzugt ebenfalls PIN-Dioden sind. Weiterhin sind die beiden Widerstände R1 und R2 einerseits mit den Dioden D3 bzw. D4 und andererseits mit einem Mittelabgriff M1 eines Spannungsteilers aus einem dritten Widerstand R3 und einem vierten Widerstand R4 verbunden.

Der Spannungsteiler ist einerseits mit einem Betriebsspannungsanschluss E_{B}, der z.B. mit derselben Spannungsquelle verbunden ist wie der Regelspannungsanchluß E_{R}, und andererseits mit dem festen Bezugspotential P verbunden.

Zwischen der dritten Diode D3 und dem ersten Widerstand R1 sowie zwischen der vierten Diode D4 und dem zweiten Widerstand R2 ist eine achte Kapazität C8 bzw. eine neunte Kapazität C9 angeschlossen, die mit ihren zweiten Anschlüssen mit dem festen Bezugspotential P verbunden ist. Diese Kapazitäten C8,C9 dienen zur Ableitung der Wechselspannung zum festen Bezugspotential P, z. B. Masse.

Die Umschaltung zwischen den einzelnen Frequenzbereichsfilterzweigen FZ1,FZ2,...,FZi wird mittels der Diodenpaare D11, D21;D12,D22;...;D1i,D2i vollzogen, die durch die Schalter S1,S2,...,Si wahlweise in Fluss gebracht werden.

Das jeweils aktive Diodenpaar D11,D21;D12,D22;...;D1i,D2i wird hier vorteilhafterweise gleichzeitig als Längsglied eines regelbaren Π-Dämpfungsgliedes genutzt, dessen Querglieder die dritte und die vierte Diode D3,D4 sind. Letztere sind im aufgeregelten Zustand stromlos (hochohmig). Bei Abregelung der Regelspannung U_{R} fließt durch sie Strom und sie werden niederohmiger, während der Strom durch das jeweilige aktive Diodenpaar D11,D21;D12,D22;...;D1i,D2i des in Betrieb befindlichen Frequenzbereichsfilterzweiges FZ1,FZ2,...,FZi mit der Regelspannung sinkt, wodurch diese hochohmiger werden.

## Patentansprüche

1. Bandpassfilter, bei dem
zwischen einem Bandpassfilter-Eingang (IN) und einem Bandpassfilter-Ausgang (OUT) eine Reihenschaltung, bestehend aus einer ersten Kapazität (C1), einem ersten parallelen LC-Glied (L_{P}1, C_{P}1), einer zweiten Kapazität (C2) und einer Induktivität (L), angeschlossen ist, bei der die einzelnen Elemente in der vorgenannten Reihenfolge direkt hintereinandergeschaltet sind,
in einer Verbindungsleitung zwischen dem ersten parallelen LC-Glied (L_{P}1,C_{P}1) und der zweiten Kapazität (C2) ein zweites paralleles LC-Glied (L_{P}2,C_{P}2) angeschlossen ist, dessen zweiter Anschluss über eine dritte Kapazität (C3) an ein festes Bezugspotential (P) gekoppelt ist,
in einer Verbindungsleitung zwischen der zweiten Kapazität (C2) und der Induktivität (L) ein drittes paralleles LC-Glied (L_{P}3,C_{P}3) angeschlossen ist, dessen zweiter Anschluss direkt oder über eine vierte Kapazität (C4) an das feste Bezugspotential (P) gekoppelt ist.

2. Bandpassfilter nach Anspruch 1, bei dem die Verbindungsleitung zwischen der zweiten Kapazität (C2) und der Induktivität (L) über eine fünfte Kapazität (C5) an das feste Bezugspotential (P) gekoppelt ist.

3. Schaltungsanordnung mit einer Mehrzahl von Bandpassfiltern (F1,F2,...,Fi) gemäß Anspruch 1 oder 2, bei der
eine Mehrzahl von Frequenzbereichsfilterzweigen (FZ1,FZ2,...,FZi) zwischen einem Wechselspannungseingangsanschluß (IN_{RF}) und einem Wechselspannungsausgangsanschluß (OUT_{RF}) angeordnet ist,
in jedem Frequenzbereichsfilterzweig (FZ1,FZ2,...,FZi) mindestens ein Bandpassfilter (F1,F2,...,Fi) gemäß Anspruch 1 oder 2 seriell zwischen mindestens einer ersten und mindestens einer zur ersten bezüglich ihrer Durchlassrichtung entgegengesetzt gerichtet geschalteten zweiten Diode (D11,D21;D12,D22;...;D1i,D2i) angeordnet ist,
in jedem Frequenzbereichsfilterzweig (FZ1,FZ2, ...,FZi) eine Schalteinheit (SE1,SE2,...,SEi) vorgesehen ist, mit der im Betrieb der Schaltungsanordnung zum Einschalten des zugehörigen Bandpaßfilters (F1,F2,...,Fi) die erste und die zweite Diode (D11,D21;D12,D22;...;D1i,D2i) dieses Frequenzbereichsfilterzweiges (FZ1,FZ2,...,FZi) auf Durchlaß geschaltet werden,
ein erster Anschluß einer dritten Diode (D3) mit einem ersten Knoten (K1) und ein erster Anschluß einer vierten Diode (D4) mit einem zweiten Knoten (K2) der parallel zueinander verschalteten Frequenzbereichsfilterzweige (FZ1,FZ2,...,FZi) verbunden ist, derart, dass die Kathoden der dritten und der vierten Diode (D3,D4) mit den Anoden der ersten Dioden (D11,D12,...,D1i) beziehungsweise der zweiten Dioden (D21,D22,...,D2i) verbunden sind,
jeweils ein zweiter Anschluß der dritten und der vierten Diode (D3,D4) an einen ersten bzw. einen zweiten Anschluß (A1,A2) für eine lastabhängige Gleichspannungsquelle (U_{LG}) gekoppelt ist und
sowohl der erste Knoten (K1) als auch der zweite Knoten (K2) an einen Gleichspannungsanschluß (E_{R}) gekoppelt sind.

4. Schaltungsanordnung nach Anspruch 3,
bei der sowohl die ersten und die zweiten Dioden (D11,D21;D12,D22;...;D1i,D2i) als auch die dritte und die vierte Diode (D3,D4) PIN-Dioden sind.

5. Schaltungsanordnung nach Anspruch 3 oder 4, bei der die Schalteinheiten (SE1,SE2,...,SEi) jeweils aufweisen,
einen ersten elekrischen Widerstand (R11,R12,...,R1i) und einem zweiten elektrischen Widerstand (R21,R22,...,R2i), die jeweils einerseits am Eingang bzw. am Ausgang des zugehörigen Frequenzbereichsfilters (F1,F2,...,Fi) angeschlossen sind und andererseits miteinander verbunden sind,
einen Ein-Aus-Schalter (S1,S2,...,Si), der einerseits zwischen dem ersten elekrischen Widerstand (R11,R12,...,R1i) und dem zweiten elektrischen Widerstand (R21,R22,...,R2i) angeschlossen ist und andererseits mit einem festen Bezugspotential (P) verbunden ist und
eine Kapazität (CF1,CF2,...,CFi), die ebenfalls einerseits zwischen dem ersten elekrischen Widerstand (R11,R12,...,R1i) und dem zweiten elektrischen Widerstand (R21,R22,...,R2i) angeschlossen ist und andererseits mit einem festen Bezugspotential (P) verbunden ist.

## Claims

1. Bandpass filter in which
a series circuit, comprising a first capacitor (C1), a first parallel LC element (L_{P}1, C_{P}1), a second capacitor (C2) and an inductor (L), is connected between a bandpass filter input (IN) and a bandpass filter output (OUT), the individual elements in the series circuit being connected directly one after the other in the aforementioned sequence, a second parallel LC element (Lₚ2, Cₚ2), whose second connection is coupled to a fixed reference-earth potential (P) via a third capacitor (C3), is connected in a connection line between the first parallel LC element (L_{P}1, C_{P}1) and the second capacitor (C2), and a third parallel LC element (Lₚ3, Cₚ3), whose second connection is coupled to the fixed reference-earth potential (P) directly or via a fourth capacitor (C4), is connected in a connection line between the second capacitor (C2) and the inductor (L).

2. Bandpass filter according to Claim 1, in which the connection line between the second capacitor (C2) and the inductor (L) is coupled to the fixed reference-earth potential (P) via a fifth capacitor (C5).

3. Circuit arrangement having a plurality of bandpass filters (F1, F2, ..., Fi) according to Claim 1 or 2, in which
a plurality of frequency domain filter paths (FZ1, FZ2, ..., FZi) are arranged between an AC voltage input connection (IN_{RF}) and an AC voltage output connection (OUT_{RF}),
at least one bandpass filter (F1, F2, ..., Fi) according to Claim 1 or 2 is arranged in series between at least one first and at least one second diode (D11, D21; D12, D22; ...; D1i, D2i), the second of which is connected with its forward direction oriented oppositely to that of the first, in each frequency domain filter path (FZ1, FZ2, ..., FZi),
each frequency domain filter path (FZ1, FZ2, ... FZi) is provided with a switching unit (SE1, SE2, ..., SEi) which is used to switch on the first and the second diode (D11, D21; D12, D22; ...; D1i, D2i) in this frequency domain filter path (FZ1, FZ2, ..., FZi) during operation of the circuit arrangement for turning on the associated bandpass filter (F1, F2, ..., Fi),
a first connection of a third diode (D3) is connected to a first node (K1) and a first connection of a fourth diode (D4) is connected to a second node (K2) of the frequency domain filter paths (FZ1, FZ2, ..., FZi) connected in parallel with one another, such that the cathodes of the third and the fourth diode (D3, D4) are connected to the anodes of the first diodes (D11, D12, ..., D1i) and of the second diodes (D21, D22, ..., D2i), respectively,
a respective second connection of the third and of the fourth diode (D3, D4) is coupled to a first and a second connection (A1, A2), respectively, for a load-dependent DC voltage source (U_{LG}), and
both the first node (K1) and the second node (K2) are coupled to a DC voltage connection (E_{R}).

4. Circuit arrangement according to Claim 3, in which both the first and the second diodes (D11, D21; D12, D22; ...; D1i, D2i) and the third and the fourth diode (D3, D4) are PIN diodes.

5. Circuit arrangement according to Claim 3 or 4, in which the switching units (SE1, SE2, ..., SEi) each have
a first electrical resistor (R11, R12, ..., R1i) and a second electrical resistor (R21, R22, ..., R2i) which are respectively connected, on the one hand, to the input and to the output of the associated frequency domain filter (F1, F2, ..., Fi) and, on the other hand, to one another,
an on/off switch (S1, S2, ..., Si) which is connected, on the one hand, between the first electrical resistor (R11, R12, ..., R1i) and the second electrical resistor (R21, R22, ..., R2i), and, on the other hand, to a fixed reference-earth potential (P), and
a capacitor (CF1, CF2, ..., CFi) which is likewise connected, on the one hand, between the first electrical resistor (R11, R12, ..., R1i) and the second electrical resistor (R21, R22, ..., R2i), and, on the other hand, to a fixed reference-earth potential (P).

## Revendications

1. Filtre passe-bande, dans lequel
il est connecté, entre une entrée (IN) de filtre passe-bande et une sortie (OUT) de filtre passe-bande, un circuit série constitué d'un premier condensateur (C1), d'un premier élément LC (L_{P}1, C_{P}1) en parallèle, d'un deuxième condensateur (C2) et d'une inductance (L), dans lequel les divers éléments se succèdent directement dans l'ordre mentionné ci-dessus,
il est connecté dans une ligne de liaison, entre le premier élément LC (L_{P}1, C_{P}1) en parallèle et le deuxième condensateur (C2), un deuxième élément LC (L_{P}2, C_{P}2) en parallèle, dont la deuxième borne est couplée par un troisième condensateur (C3) à un potentiel (P) de référence fixe,
dans une ligne de liaison il est connecté, entre le deuxième condensateur (C2) et l'inductance (L), un troisième élément LC (L_{P}3, C_{P}3) en parallèle, dont la deuxième borne est couplée directement ou par l'intermédiaire d'un quatrième condensateur (C4) au potentiel (P) de référence fixe.

2. Filtre passe-bande suivant la revendication 1, dans lequel la ligne de liaison entre le deuxième condensateur (C2) et l'inductance (L) est couplée par un cinquième condensateur (C5) au potentiel (P) de référence fixe.

3. Circuit comprenant une multiplicité de filtres passe-bande (F1, F2, ..., Fi) suivant la revendication 1 ou 2, dans lequel il est prévu une multiplicité de branches (FZ1, FZ2, ..., FZi) de filtre de domaine de fréquences entre une borne (IN_{RF}) d'entrée de tension alternative et une borne (OUT_{RF}) de sortie de tension alternative,
dans chaque branche (FZ1, FZ2, ..., FZi) de filtre de domaine de fréquences il est monté au moins un filtre passe-bande (F1, F2, ... Fi) suivant la revendication 1 ou suivant la revendication 2 en série entre au moins une première et au moins une deuxième diode (D11, D21 ; D12, D22 ; ... ; D1i, D2i) montée en sens inverse de la première,
dans chaque branche (FZ1, FZ2, ..., FZi) de filtre de domaine de fréquences il est prévu une unité (SE1, SE2, ..., SEi) de commutation par laquelle, lorsque le circuit fonctionne pour mettre sous tension le filtre passe-bande (F1, F2, ..., Fi) correspondant, la première et la deuxième diode (D11, D21 ; D12, D22 ;... ; D1i, D2i) de cette branche (FZ1, FZ2, ..., FZi) de filtre de domaine de fréquences sont mises à l'état passant,
une première borne d'une troisième diode (D3) est reliée à un premier noeud (K1) et une première borne d'une quatrième diode (D4) est reliée à un deuxième noeud (K2) des branches (FZ1, FZ2, ..., FZi) de filtre de domaine de fréquences montées en parallèle l'une avec l'autre, de façon que les cathodes de la troisième et de la quatrième diode (D3, D4) soient reliées aux anodes de la première diode (D11, D12, ..., D1i) et respectivement de la deuxième diode (D21, D22, ..., D2i),
respectivement une deuxième borne de la troisième et de la quatrième diode (D3, D4) sont couplées à une première ou à une deuxième borne (A1, A2) pour une source (U_{LG}) de tension continue en fonction de la charge et
tant le premier noeud (K1) que le deuxième noeud (K2) sont couplés à une borne (E_{R}) de tension continue.

4. Circuit suivant la revendication 3, dans lequel tant les premières que les deuxièmes diodes (D11, D21 ; D12, D22 ; ... ; D1i, D2i) que les troisièmes et les quatrièmes diodes (D3, D4) sont des diodes PIN.

5. Circuit suivant la revendication 3 ou 4, dans lequel les unités (SE1, SE2, ..., SEi) de commutation comportent respectivement une première résistance (R11, R12, ..., R1i) électrique et une deuxième résistance (R21, R22, ..., R2i) électrique qui sont raccordées respectivement d'une part à l'entrée ou à la sortie du filtre (F1, F2, ..., Fi) de domaine de fréquences associé et d'autre part sont reliées entre elles,
un interrupteur (S1, S2, ..., Si) de marche-arrêt, qui est raccordé d'une part entre la première résistance (R11, R12, ..., R1i) électrique et la deuxième résistance (R21, R22, ..., R2i) électrique et qui est reliée d'autre part à un potentiel (P) de référence fixe et
un condensateur (CF1, CF2, ..., CFi), qui est raccordé également d'une part entre la première résistance (R11, R12, ..., R1i) électrique et la deuxième résistance (R21, R22, ..., R2i) électrique et qui est relié d'autre part à un potentiel (P) de référence fixe.
